# EUROPEAN PATENT APPLICATION

(11) **EP 1 170 790 A1**
(43) Date of publication of application: **09.01.2002**
(21) Application number: 00981728.9
(22) Date of filing: 14.12.2000
(51) Int. Cl.: H01L 21/68, H01L 21/02, H05B 3/16, H05B 3/18, H05B 3/20, H05B 3/68

(54) **CERAMIC HEATER AND SUPPORT PIN**

(30) Priority: 14.12.1999 JP 35510899; 03.04.2000 JP 2000101563
(71) Applicant: Ibiden Co., Ltd., Ogaki-shi, Gifu 503-0917 (JP)
(72) Inventor: HIRAMATSU, Yasuji, Ibi-gun, Gifu 501-0695 (JP); ITO, Yasutaka, Ibi-gun, Gifu 501-0695 (JP)
(74) Representative: Gillard, Marie-Louise
(86) International application number: JP0008871
(87) International publication number: WO0145160

(57) **Abstract**

The present invention provides a ceramic heater which makes it possible to make the distance between a semiconductor wafer and the heating surface of a ceramic substrate constant at any time, heat the semiconductor wafer at an even temperature and prevent contamination of the semiconductor wafer, and which does not cause dropping-out of a supporting pin. The ceramic heater of the present invention comprises a ceramic substrate on a surface of which or inside which a heating element is formed, wherein the ceramic heater is constituted to have a structure that an object to be heated can be held apart from a surface of said ceramic substrate and heated.

## Description

### Technical Field

The present invention relates mainly to a ceramic heater (semiconductor wafer heating device) used to heat a semiconductor wafer and the like, and a supporting pin used in a ceramic substrate constituting the ceramic heater (semiconductor wafer heating device).

### Background Art

Hitherto, a heater using a metal base material, such as stainless steel or aluminum alloy, has been used in semiconductor producing or examining devices containing an etching device, a chemical vapor deposition device and the like.

However, a heater made of a metal has problems that its temperature controlling property is poor and its thickness also becomes thick so that the heater is heavy and bulky. The heater also has a problem that corrosion resistance against corrosive gas is poor.

In light of these problems, JP Kokai Hei 11-40330 and so on disclose a heater wherein a ceramic such as aluminum nitride is used instead of a metal.

### Summary of the Invention

However, such a heater is used in the condition that an object to be heated, such as a semiconductor wafer, is put on a ceramic substrate in the state that the object contacts the ceramic substrate. Thus, temperature distribution on the surface of the ceramic substrate is reflected on the semiconductor wafer so that the semiconductor wafer or the like cannot be uniformly heated.

If one attempts to make the surface temperature of the ceramic substrate uniform so as to heat the semiconductor wafer or the like uniformly, highly complicated control is necessary. Thus, the control of the temperature is not easy.

An objective of the present invention is to solve the problems associated with the above-mentioned prior art, and to provide: a ceramic heater making it possible to heat uniformly the whole body of an object to be heated, such as a semiconductor wafer, particularly at the temperature range of 100 °C or higher; and a supporting pin, for supporting the object to be heated, used in the ceramic heater.

The present invention is a ceramic heater (heating device) used to heat an object to be heated, such as a semiconductor wafer.

A first aspect of the present invention is a ceramic heater (semiconductor wafer heating device) comprising a ceramic substrate, on a surface of which or inside which, a heating element is formed, wherein the ceramic heater is constituted to have a structure that an object to be heated can be held apart from a surface of the ceramic substrate and heated.

A second aspect of the present invention is a ceramic heater comprising a ceramic substrate, on a surface of which or inside which, a heating element is formed, wherein the ceramic heater is constituted: to have a structure that a face of the ceramic substrate on which no heating element is formed, or one face of the ceramic substrate is made to be a heating surface; and to have a structure that an object to be heated, such as a semiconductor wafer, can be held apart from the heating surface and heated.

In the ceramic heater, a through hole in which a supporting pin for holding the object to be heated such as a semiconductor wafer is passed through is desirably formed in the ceramic substrate. The semiconductor wafer is desirably 5 to 5000 µm apart from the surface or the heating surface of the ceramic substrate.

In the ceramic heater, a convex body is desirably formed on the surface of the ceramic substrate. For this purpose, it is desired that a through hole is formed in the ceramic substrate, and a supporting pin is passed through and fixed into the through hole so that the convex body is formed on the surface of the ceramic substrate, or it is desired that a concave portion is formed on the heating surface of the ceramic substrate, and a supporting pin is inserted and fixed into the concave portion so that the convex body or the convex portion is formed on the surface of the ceramic substrate.

The convex body is preferably in a spire shape or hemisphere shape which can make a point contact with the object to be heated. Also, a tip of the supporting pin is preferably in a spire shape or in a hemispherical shape.

A third aspect of the present invention is a supporting pin, wherein: a contact portion formed at a tip; a fitting-in portion formed under the contact portion which has a larger diameter than that of the contact portion; a pillar-shaped body formed under the fitting-in portion which has a smaller diameter than that of the fitting-in portion; and a fixing portion formed on the lower end of the pillar-shaped body which has a larger diameter than that of the pillar-shaped body; are integrated to one body.

A fourth aspect of the present invention is a supporting pin, wherein: a pillar-shaped body; and a fixing portion having a larger diameter than that of the pillar-shaped body are integrated to one body.

In the supporting pin according to the fourth aspect of the present invention, the tip of the pillar-shaped body is desirably in a spire shape or in a hemispherical shape.

A fifth aspect of the present invention is a ceramic heater: comprising a ceramic substrate, on a surface of which or inside which, a heating element is formed; and which is constituted to have a structure that an object to be heated, such as a . semiconductor wafer, can be held apart from a surface of the ceramic substrate and heated, wherein: a through hole composed of connected holes, said holes having mutually different diameters, is formed in the ceramic substrate; the supporting pin according to the third aspect of the present invention is passed through the through hole; the fitting-in portion of the supporting pin is inserted and fitted into the portion(hole) with the relatively large diameter of the through hole; and a metal member for fixing is fitted in between the fixing portion of the supporting pin and the bottom surface of the ceramic substrate.

A sixth aspect of the present invention is a ceramic heater: comprising a ceramic substrate, on a surface of which or inside which, a heating element is formed; and which is constituted to have a structure that a semiconductor wafer can be held apart from a surface of the ceramic substrate and heated, wherein: a concave portion is formed in the heating surface side of the ceramic substrate; the supporting pin according to the fourth aspect of the present invention is inserted into the concave portion; and a spring for fixing is fitted to the concave portion so as to contact the wall surface of the concave portion in the state that the spring for fixing surrounds the pillar-shaped body.

In the ceramic heater, an electrostatic electrode is desirably set up inside the ceramic substrate.

### Brief Description of Drawings

FIG. 1 is a plain view that schematically illustrates a ceramic substrate constituting the ceramic heater of the present invention.
FIG. 2 is a partially enlarged sectional view of the ceramic substrate illustrated in FIG. 1.
FIG. 3 is a plain view that schematically illustrates another example of a ceramic substrate constituting the ceramic heater of the present invention.
FIGs. 4(a) and (b) are front views, each of which schematically illustrates a supporting pin of the present invention.
FIG. 5(a) is a partially enlarged sectional view that schematically illustrates a ceramic substrate constituting the ceramic heater of the present invention, and FIG. 5(b) is a perspective view illustrating a metal member for fixing.
FIG. 6(a) is a partially enlarged sectional view that schematically illustrates a ceramic substrate constituting the ceramic heater of the present invention, and FIG. 6(b) is a perspective view that schematically illustrates the manner that a supporting pin is fitted in a concave portion in the ceramic substrate.
FIG. 7 is a partially enlarged sectional view that schematically illustrates a ceramic substrate constituting the ceramic heater (an electrostatic chuck) of the present invention.
FIG. 8 is a partially cutaway perspective view that schematically illustrates a ceramic substrate constituting the ceramic heater of the present invention.
FIG. 9 is a partially cutaway perspective view that schematically illustrates a ceramic substrate constituting the ceramic heater of the present invention.
FIG. 10 (a) is a sectional view that illustrates a convex body having a hemispherical portion set in a concave portion in a ceramic substrate, and FIG. 10(b) is a sectional view that illustrates a spherical convex body.

### Explanation of symbols

- 1, 11, 81, 91: a ceramic substrate
- 1c, 11c: a bottomed hole
- 1a, 11a: a heating surface
- 1b, 11b: a bottom surface
- 2, 12: a resistance heating element
- 3: a terminal pin
- 4: a heating element layer
- 5: a metal covering layer
- 6: a solder layer
- 7: a lifter pin
- 8: a through hole
- 9: a silicon wafer
- 13: a temperature-measuring element
- 15: a plated through hole
- 16: a blind hole
- 20, 30: a supporting pin
- 21: a contact portion (spire portion)
- 22: a fitting-in portion
- 23: a pillar-shaped portion
- 24: a fixing portion
- 27: a metal member
- 31: a pillar-shaped body
- 32: a fixing portion
- 37: a spring
- 41: a through hole
- 42: a concave portion
- 43: an electrostatic electrode
- 81d, 91d: a convex portion

### Detailed Disclosure of the Invention

All of the ceramic heaters of the present invention have a common characteristic that they are made in the manner that a semiconductor wafer is held apart from a surface (heating surface) of their ceramic substrate and is heated. First, therefore, this characteristic will be described, and subsequently the above-mentioned first to sixth aspects of present inventions will be appropriately described.

In the following description, a semiconductor wafer is used as an example of an object to be heated. A semiconductor wafer heating device using this semiconductor wafer will be described as an example.

In the ceramic heater (a semiconductor wafer heating device) of the present invention, in the state that its ceramic substrate does not contact the semiconductor wafer, the semiconductor wafer is heated.

By setting the semiconductor wafer and the ceramic substrate into the state that they do not contact each other, it is possible to attain the condition that the semiconductor wafer is not affected by temperature distribution of the surface of the ceramic substrate. Thus, the temperature of the whole of the semiconductor wafer can be made uniform. Upon heating, the heat of the ceramic substrate is conducted to the semiconductor wafer by a convection of the air or radiation. Since the ceramic substrate and the semiconductor wafer do not contact each other, an advantageous effect that: impurity elements, such as Na, BandY, contained in the ceramic substrate or sintering aids do not contaminate the semiconductor wafer; is also obtained.

When a ceramic substrate on a surface of which a conductor layer is formed is used, the face of a ceramic substrate on which no heating element is formed (a surface opposite to the heating-element-formed surface) is made to be a heating surface. This is because if a heating element is formed on the heating surface, a temperature distribution similar to the pattern of the heating element is generated on the semiconductor wafer.

When a heating element is formed inside, it is desired that the face farther from the heating element is made to be a heating surface. This is because as heat is conducted in the ceramic substrate, temperature becomes uniform.

The method for heating a semiconductor wafer in the state that the semiconductor wafer is held apart from a surface (heating surface) of a ceramic substrate is not particularly limited. However, as described about the second aspect of the present invention, it is desired that a convex body or convex portion for holding the semiconductor wafer is formed in the ceramic substrate.

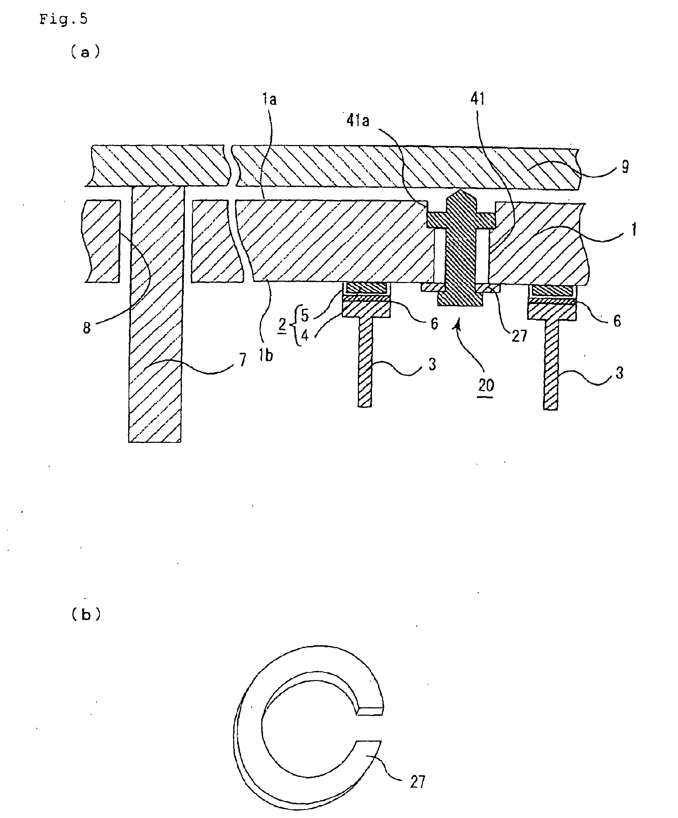

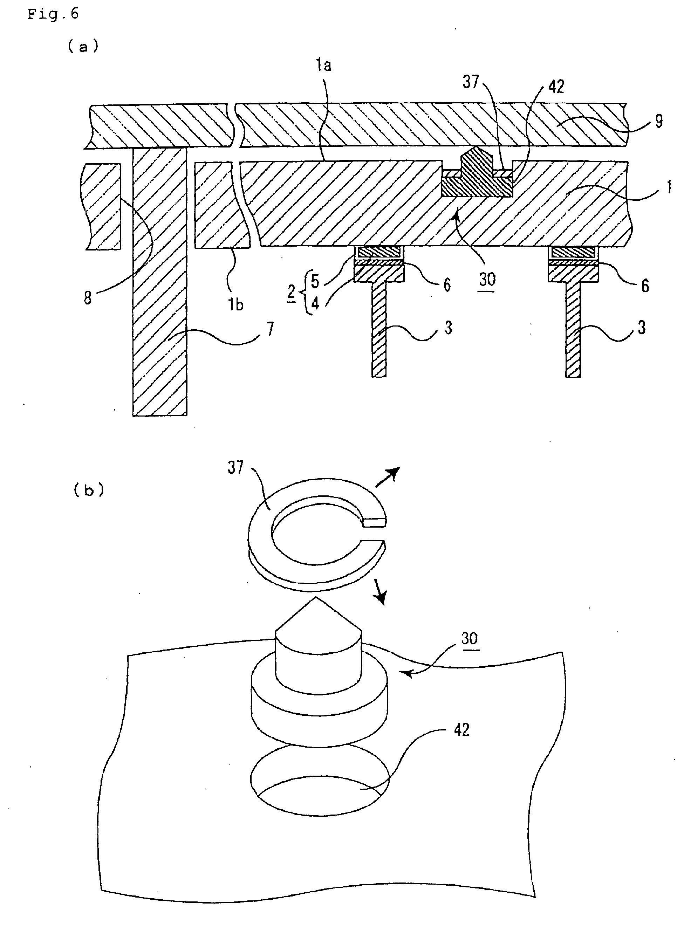

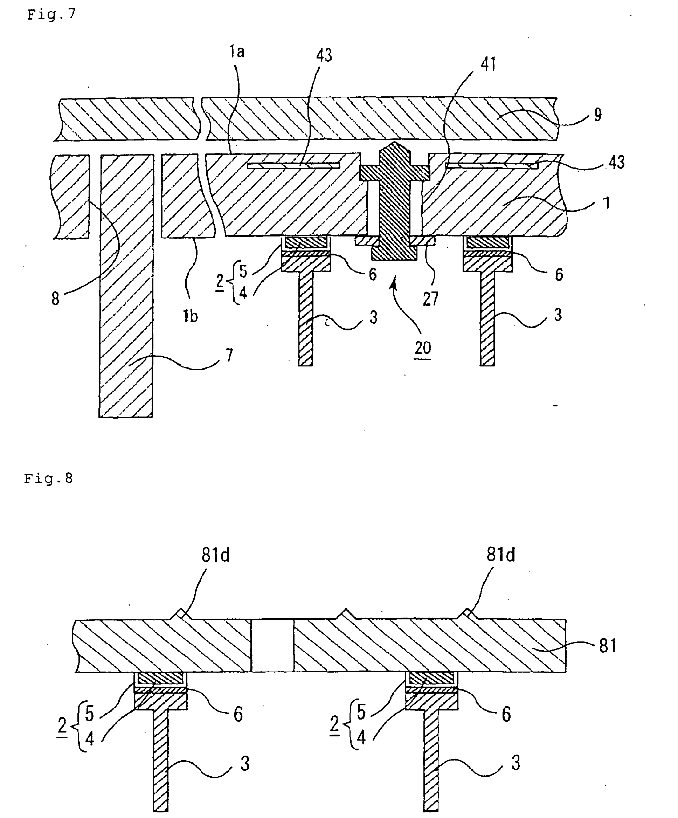

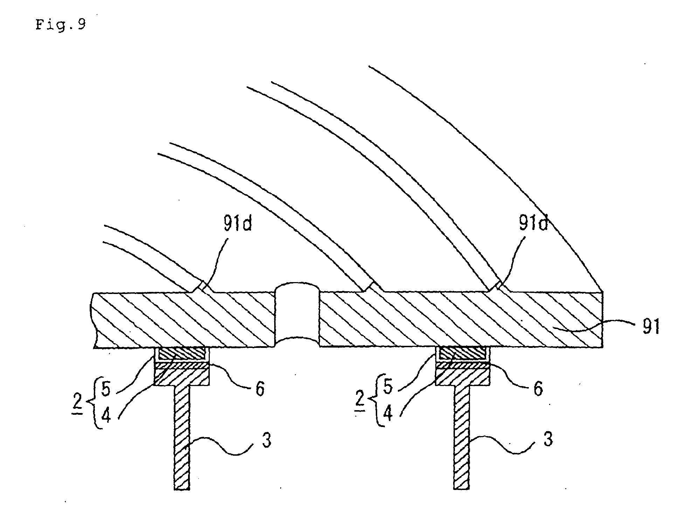

This is because the semiconductor wafer can be supported by this convex body or convex portion and can be heated apart from the heating surface. In this case, the following methods are given: as illustrated in FIGS. 8,9, a method of forming convex portions 81d,91d on surfaces of ceramic substrates 81,91 and holding a semiconductor wafer by the convex portions 81d,91d; as illustrated in FIGs. 5, 7, a method of forming a through hole 41 in a ceramic substrate 1, inserting a supporting pin 20 into this through hole 41, and holding a semiconductor wafer by the supporting pin 20; as illustrated in FIG. 6, a method of forming a concave portion 42 in a ceramic substrate 1, fixing a supporting pin 30 thereto, and holding and heating a semiconductor wafer; and so on.

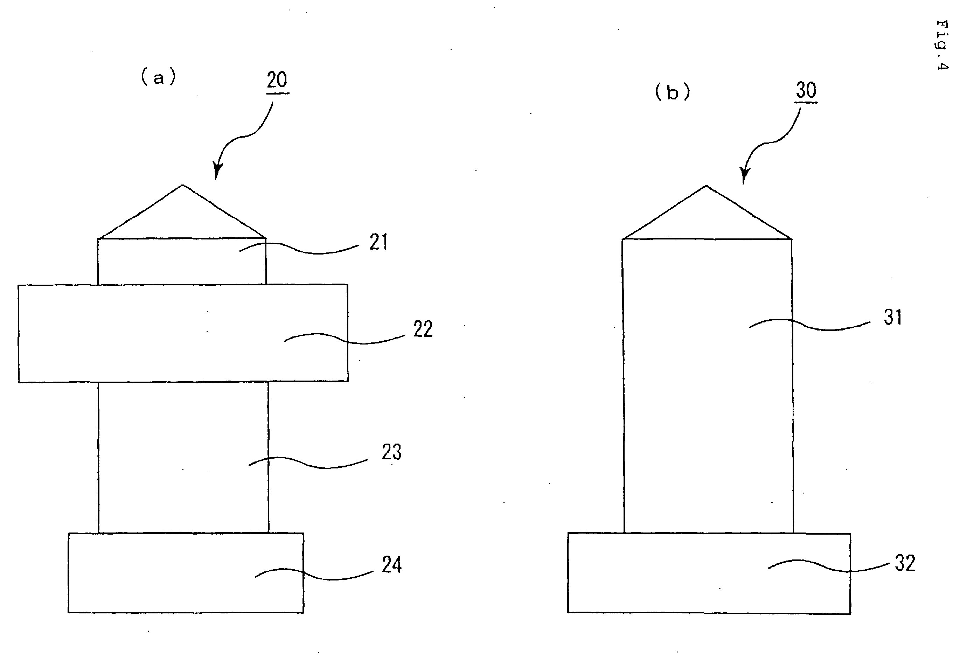

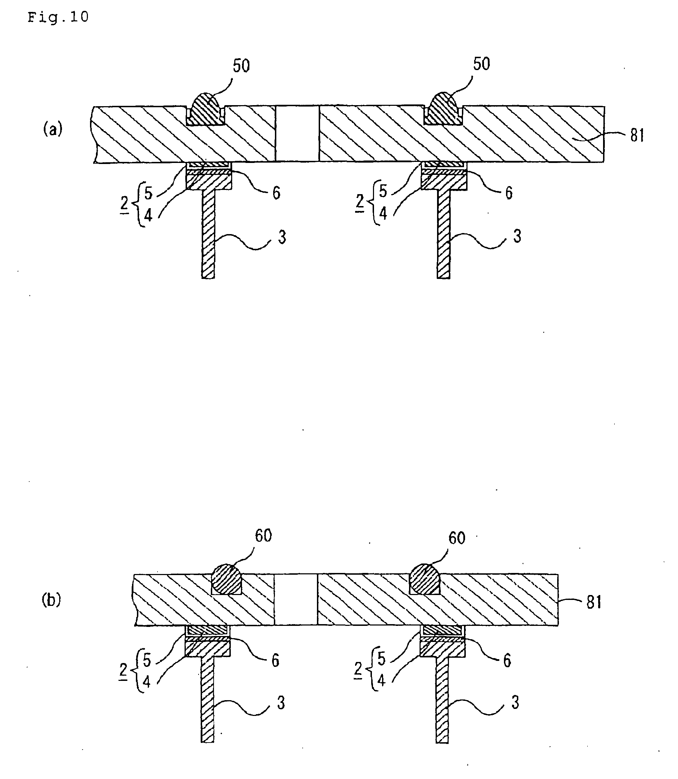

The convex body preferably has a spire shape portion 7 (reference to FIGs. 4 to 7), or a spherical or hemispherical portion (reference to FIG. 10). This is because the convex body can be set into the state of point contact with an object to be heated. As illustrated in FIG. 10, the convex body may be spherical. This is because by embedding this spherical body in a concave portion of a ceramic substrate, the contact thereof with a semiconductor wafer can be set into the point contact. FIG. 10(a) is a sectional view illustrating a convex body 50 having a hemispherical portion, and FIG. 10(b) is a sectional view illustrating a spherical convex body 60.

In the case that a convex portion is formed on the heating surface of a ceramic substrate, the portions may be convex portions 81d in a conical shape or in a pyramidic shape (a triangularpyramidic, a quadrangularpyramidic, or the like form) as illustrated in FIG. 8, or may be a convex portion 91d whose projection is formed in a ring form, as illustrated in FIG. 9.

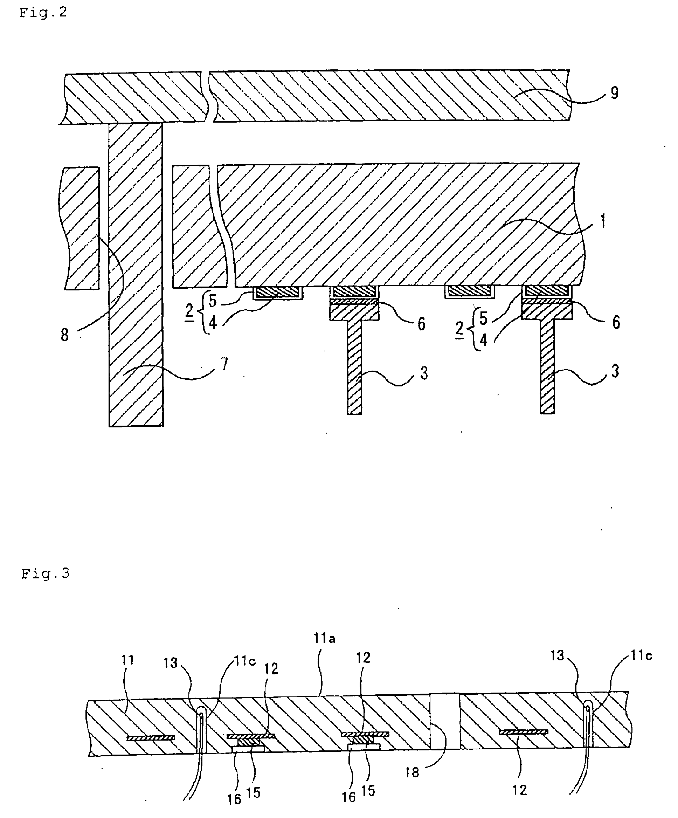

As a supporting pin, a lifter pin 7 used to receive and deliver a silicon wafer can be utilized as illustrated in FIG. 2, or a supporting pin 20,30 illustrated in FIGs. 4 (a), (b) can be used.

FIGs. 4 (a), (b) are front views, each of which schematically illustrates the shape of these supporting pins.

The supporting pin 20 illustrated in FIG. 4(a) is a pin wherein a contact portion 21, for contacting a semiconductor wafer, formed at a tip, a fitting-in portion 22 formed under the contact portion 21 which has a larger diameter than that of the contact portion 21, a pillar-shaped body 23 formed under the fitting-in portion 22 which has a smaller diameter than that of the fitting-in portion 22, and a fixing portion 24 formed on the lower end of the pillar-shaped body 23 which has a larger diameter than that of the pillar-shaped body 23 are integrated to one body.

The contact portion 21 is desirably; a spire portion in a spire plate shape or a spire pillar shape (that is, a shape having a pyramid at its tip and a prism under the pyramid, or a shape having a cone at its tip and a column under the cone) ; or a hemispherical portion in a hemispherical shape or a hemispherical pillar shape.

As illustrated in FIG. 5, the supporting pin 20 is passed through a through hole 41 composed of connected holes, said holes having mutually different diameters, and said through hole is formed in a ceramic substrate 1. Then, the fitting-in portion 22 of the supporting pin is inserted into a hole 41a having a relatively large diameter. On the other hand, the fixingportion 24 of the supporting pin 20 is exposed from a bottom surface 1b of the ceramic substrate 1, and a C figure-shaped or an E figure-shaped metal member for fixing 27 called a snap ring is fitted and fixed between the fixing portion 24 and the bottom surface 1b. Therefore, the supporting pin 20 is certainly fixed without dropping out from the ceramic substrate 1.

The tip of the supporting pin 20 is in a spire shape or a hemispherical shape and projects upward from a heating surface 1a of the ceramic substrate 1. Therefore, the supporting pin 20 is set into a point contact with a semiconductor wafer put on the ceramic substrate 1. Thus, the supporting pin 20 does not contaminate the semiconductor wafer, and any singular point (the hot spot where the temperature of a contact portion is high, or cooling spot with low temperature) is not generated.

A supporting pin 30 illustrated in FIG. 4 (b) is a supporting pin, wherein: a pillar-shaped body 31 which has a tip in a spire shape; and a fixing portion 32 having a larger diameter than that of the pillar-shaped body 31 are integrated to be one body.

As illustrated in FIG. 6, this supporting pin 30 is fixed as follows: after a concave portion 42 is formed in a ceramic substrate 1, the supporting pin 30 is inserted into the concave portion 42, and then a C figure-shaped spring 37 is fixed into a concave portion 81 so as to contact the wall surface of the concave portion 81 in the state that the spring for fixing surrounds the pillar-shaped body 31. As illustrated in FIG. 6(b), the C figure-shaped spring 37 is to open outwards. Thus, if the C figure-shaped spring 37 is inserted into a concave portion 42, the C figure-shaped spring 37 is fixed to an inner wall of the concave portion 42 by contacting with the inner wall. On the other hand, a fixing portion 32 of the supporting pin 30 is held by the C figure-shaped spring 37 so that the spring pin 30 can be certainly fixed to the inside of the concave portion 42.

The supporting pin may be formed solely at the central portion, and/or a plurality of the supporting pins may be formed at linear symmetrical or point symmetrical positions along concentric circles.

The number of the supporting pins is desirably from 1 to 10 in any ceramic substrate having a diameter of 300 mm or less.

In the case that resistance heating elements 2 are formed on a surface (bottom surface) 1b opposite to a heating surface 1a of the ceramic substrate 1, since the concave portion 42 is formed in the heating surface 1a, the freedom, or flexibility of the pattern can be increased. Further, since this concave portion 42 is not a through hole, it does not happen that the spring is off so that the supporting pin 30 drops out.

The tip of the pillar-shaped body of the supporting pin 30 is desirably in a spire shape. The reason for this is the same reason as mentioned on a supporting pin A.

The C figure-shaped metal member 27 or the spring 37 is desirably made of a metal, particularly a metal which does not easily become rusty, such as stainless steel or Ni alloy. The supporting pins 20 and 30 are desirably made of a ceramic, and are more desirably made of an oxide ceramic such as alumina or silica. This is because they have a small thermal conductivity so that cooling spots or hot spots are not easily generated.

The fixing method using the C figure-shaped metal member 27 or the spring 37 is different from a method using an adhesive agent and the like, and is a physical fixing method. The metal member 27 and the spring 37 do not deteriorate by heat and the like.

The diameters of the through hole and the concave portion are desirably from 1 to 100 mm, and more desirably from 2 to 10 mm. This is because; if the diameters are too large, cooling spots are generated.

In the present invention, a semiconductor wafer is located desirably 5 to 5000 µm and particularly desirably 5 to 500 µm apart from the surface or the heating surface of the ceramic substrate. If the distance is below 5 µm, the temperature of the semiconductor wafer becomes uneven affected by the temperature distribution of the ceramic substrate. If the distance is over 5000 µm, the temperature of the semiconductor wafer is not easily raised so that a temperature difference in the semiconductor wafer becomes large.

Particularly, the semiconductor wafer is located most desirably 20 to 200 µm apart from the surface or the heating surface of the ceramic substrate.

As illustrated in FIG. 7, in the ceramic heater of the present invention, electrostatic electrodes 43 may be formed inside a ceramic substrate 1. By sucking a semiconductor wafer, such as a silicon wafer 9, by means of the electrostatic electrodes 43, a warp of the semiconductor wafer can be directed to one direction and a dispersion in the distance between a heating surface 1a and the semiconductor wafer can be made small. As a result, the temperature of the semiconductor wafer can be made uniform, further.

It is desired that the ceramic substrate of the present invention contains carbon and the carbon content therein is from 200 to 5000 ppm. This is because the electrodes can be hidden (covered up) and black-body radiation can easily be utilized.

The diameter of the ceramic substrate of the present invention is desirably 150 mm or more, and optimally 200 mm or more. This is because; in the substrate having such a large diameter, the temperature of its heating surface is apt to become uneven and a temperature difference is easily generated in a semiconductor wafer.

The ceramic substrate of the present invention is used desirably at 100 °C or higher and particularly desirably at 200°C or higher. This is because the temperature of the heating surface is apt to become uneven and a temperature difference is easily generated in a semiconductor wafer.

The ceramic material constituting the ceramic substrate for a semiconductor device of the present invention is not especially limited. Examples thereof include nitride ceramics, carbide ceramics, and oxide ceramics.

Examples of the nitride ceramics include metal nitride ceramics suchas aluminumnitride, siliconnitride, boronnitride, and titanium nitride.

Examples of the carbide ceramics include metal carbide ceramics such as silicon carbide, zirconium carbide, titanium carbide, tantalum carbide, and tungsten carbide.

Examples of the oxide ceramics include metal oxide ceramics such as alumina, zirconia, cordierite and mullite.

These ceramics may be used alone or in combination of two or more thereof.

Among these ceramics, nitride ceramics and carbide ceramics are more preferred to oxide ceramics. This is because they have a high thermal conductivity.

Aluminum nitride is most preferred among nitride ceramics since its thermal conductivity is highest, that is, 180 W/m · K.

In the present invention, it is desired that the ceramic substrate contains a sintering aid. The sintering aid that can be used may be an alkali metal oxide, an alkali earth metal oxide or a rare element oxide, and is particularly preferably CaO, Y₂O₃, Na₂O, Li₂O or Rb₂O among these sintering aids. The content of these sintering aids is desirably from 0.1 to 10 % by weight.

In the above-mentioned ceramic substrate, its brightness is desirably N4 or less as the value based on the rule of JIS Z 8721. This is because the ceramic substrate having such a brightness is superior in radiant heat capacity and covering-up ability.

The brightness N represents a brightness scale with the brightness of ideal black being taken as 0 and the brightness of ideal white as 10 and the brightness of a sample is expressed on the scale divided in 10 at equal intensity intervals of perceptual brightness, as NO to N10.

In actual measurement, a comparison is made with color cards corresponding to N0 to N10. In this case, decimal fractions are rounded to 0 or 5.

The heating element arranged on a surface of the ceramic substrate of the present invention or inside the ceramic substrate is desirably made of a metal or a conductive ceramic. Preferred examples of the metal include noble metals (gold, silver, platinum and palladium), lead, tungsten, molybdenum, andnickel. Examples of the conductive ceramic include carbides of tungsten and molybdenum. These may be used alone or in combination of two or more.

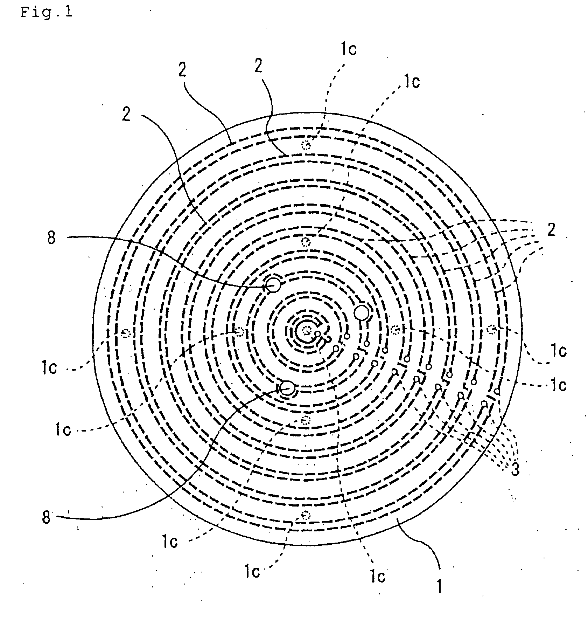

FIG. 1 is a plain view that illustrates a ceramic substrate constituting the ceramic heater of the present invention.

FIG. 2 is a partially enlarged sectional view thereof.

A ceramic substrate 1 is made in a disc form. Resistance heating elements 2 are formed in the form of concentric circles on the bottom surface of the ceramic substrate 1 in order to heat a heating surface 1a of the ceramic substrate 1 in the manner that the temperature thereof will be wholly uniform. The resistance heating elements 2 are comprising a heating element layer 4 and a metal covering layer 5.

About these resistance heating elements 2, two concentric circles near to each other, as a pair, are connected to produce one line. To both ends thereof are connected terminal pins 3, which will be inputting/outputting terminals, through a solder layer 6. Through holes 8, into which lifter pins 7 will be passed through, are formed in an area near the center of the ceramic substrate 1. Bottomed holes 1c, in which temperature-measuring elements will be inserted, are formed on the bottom surface.

As shown in FIG. 2, the lifter pins 7 with a silicon wafer 9 put thereon, can be moved up and down. In this way, the silicon wafer 9 can be delivered to a non-illustrated carrier equipment or can be received from the carrier equipment. In the present invention, the lifter pins 7 receive the silicon wafer 9 and subsequently the lifter pins 7 are lowered to hold the silicon wafer 9, 5 to 5000 µm apart from the surface of the ceramic substrate 1 and heat the wafer. The heating is desirably performed at 150 °C or higher.

FIG. 3 is a sectional view that schematically illustrates a ceramic substrate in which resistance heating elements are embedded therein.

In this case, the resistance heating elements 12 are usually formed in the ceramic substrate 11 and nearer to the bottom surface thereof than the center thereof. However, the resistance heating elements 12 may be formed being biased nearer to a heating surface 11a than the center. Plated through holes 15 are formed just under end portions of the resistance heating elements 12. Blind holes 16 are formed under the plated through holes 15 so that the plated through holes 15 are exposed. By connecting conductive wires (not illustrated) and so on to the exposed plated through holes 15, electric current can be applied to the resistance heating elements 12.

The following will describe one example of the method for producing the ceramic heater according to the present invention.
(1) First, ceramic powder, a binder, a sintering aid and so on are mixed. The average particle diameter of the mixed powder is preferably about 0.1 to 5 µm. As the diameter is finer, the sinterability is made higher. However, if the diameter is too fine, the bulk density of the green product becomes small and the degree of contraction during sintering becomes large. Thus, the dimensional accuracy may be insufficient.
   When an aluminum nitride substrate or the like is produced, a sintering aid such as yttrium oxide (yttria: Y₂O₃) may be added to the above-mentioned mixture.
(2) Next, a formed body obtained by putting the resultant powder mixture into a mold, or a lamination of the green sheets (each of which is pre-fired) is heated and pressed at 1700 to 1900 °C and 8 to 20 MPa in the atmosphere of an inert gas such as argon nitrogen, so as to be sintered.

The ceramic substrate can be basically produced by firing the formed body comprising the ceramic powder mixture or the green sheet lamination. Thus, a ceramic substrate having therein the resistance heating elements can be produced by the following manner: by embedding a metal plate (foil), a metal wire or the like, which will be resistance heating elements, in the powder mixture at the time of putting the ceramic powder mixture into the mold; or by forming a conductor containing paste layer, which will be resistance heating elements, on one green sheet among the laminated green sheets.

By producing a sintered body, forming a conductor containing paste layer on the surface (bottom surface) thereof and then, firing the product, heating elements can be formed on the bottom surface.

The conductor containing paste for producing the heating elements is not particularly limited, and is preferably a paste comprising not only metal particles or a conductive ceramic for keeping electrical conductivity but also a resin, a solvent, a thickener and so on.

The metal particles are preferably of, for example, a noble metal (gold, silver, platinum and palladium), lead, tungsten, molybdenum, nickel or the like. These may be used alone or in combination of two or more. These metals are not relatively easily oxidized and, when they are made to thin layered electrodes or the like, have a sufficiently large conductivity. On the other hand, when they are made to linear (band-form) resistance heating elements as shown in FIG. 1, they have a sufficient resistance value for generating heat.

Examples of the conductive ceramic include carbides of tungsten and molybdenum. These may be used alone or in combination of two or more.

The particle diameter of these metal particles or the conductive ceramic is preferably 0.1 to 100 µm. If the particle diameter is too fine, that is, below 0.1 µm, they are easily oxidized. On the other hand, if the particle diameter is over 100 µm, they are not easily sintered so that the resistance value becomes large.

The shape of the metal particles maybe spherical or scaly. When these metal particles are used, they may be a mixture of spherical particles and scaly particles.

In the case that the metal particles are scaly or a mixture of spherical particles and scaly particles, metal oxides between the metal particles are easily retained and adhesiveness between the heating elements and the ceramic substrate is made sure. Moreover, the resistance value can be made large. Thus, this case is profitable.

Examples of the resin used in the conductor containing paste include epoxy resins and phenol resins. An example of the solvent is isopropyl alcohol. An example of the thickener is cellulose.

When the conductor containing paste for the resistance heating elements is formed on the surface of the ceramic substrate, it is desired to add a metal oxide besides the metal particles to the conductor containing paste and sinter the metal particles and the metal oxides. By sintering the metal oxide together with the metal particles in this way, the ceramic substrate can be closely adhered to the metal particles.

The reason why the adhesiveness to the ceramic substrate is improved by mixing the metal oxide is unclear, but would be based on the following. The surface of the metal particles or the surface of the ceramic substrate is slightly oxidized so that an oxidized film is formed. Pieces of these oxidized films are sintered and integrated with each other through the metal oxide so that the metal particles and the ceramic substrate are closely adhered to each other. In the case that the ceramic constituting the ceramic substrate is an oxide, the surface is naturally comprising the oxide. Therefore, a conductor layer superior in adhesiveness is formed.

A preferred example of the metal oxide is at least one selected from the group consisting of lead oxide, zinc oxide, silica, boron oxide (B₂O₃), alumina, yttria, and titania.

These oxides make it possible to improve adhesiveness between the metal particles and the ceramic substrate without increasing the resistance value of the heating elements.

When the total amount of the metal oxides is set to 100 parts by weight, the weight ratio of lead oxide, zinc oxide, silica, boron oxide (B₂O₃), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. The ratio is preferably adjusted within the scope that the total thereof is not over 100 parts by weight.

By adjusting the amounts of these oxides within these ranges, the adhesiveness to the ceramic substrate can be particularly improved.

The addition amount of the metal oxides to the metal particles is preferably 0.1 % by weight or more and less than 10 % by weight. The area resistivity when the conductor containing paste having such a composition is used to form the heating elements is preferably from 1 to 10000 mΩ/□.

If the area resistivity is over 1000 mΩ/□, the calorific value for an applied voltage becomes too small so that, in ceramic substrate wherein the heating elements are set on its surface, their calorific value is not easily controlled.

In the case that the heating elements are formed on the surface of the ceramic substrate, a metal covering layer is preferably formed on the surface of the heating elements. The metal covering layer prevents a change in the resistance value owing to oxidization of the inner metal sintered body. The thickness of the formed metal covering layer is preferably from 0.1 to 10 µm.

The metal used when the metal covering layer is formed is not particularly limited if the metal is a metal which is not easily oxidized. Specific examples thereof include gold, silver, palladium, platinum, and nickel. These may be used alone or in combination of two or more. Among these metals, nickel is preferred.

In the case that the heating elements are formed inside the ceramic substrate, no coating is necessary since the surface of the heating elements is not oxidized.

Next, through holes or concave portions, into which supporting pins will be inserted, are formed in the ceramic substrate having the resistance heating elements. The supporting pins are inserted thereinto. External terminals and so on are connected thereto. If necessary, bottomed holes are formed and thermocouples are buried therein.

The thus obtained ceramic substrate is set on a supporting case or the like. Wires from the resistance heating elements and temperature-measuring elements are connected to a control device. In such a way, the manufacturing of a semiconductor wafer heating device (ceramic heater) is finished.

A semiconductor wafer is held by the convex portion and so on formed on the ceramic substrate to keep a space having a distance of 5 to 500 µm between the semiconductor wafer and the ceramic substrate. The semiconductor wafer is heated at 150 °C or higher to make it possible to subject the wafer to various treatments.

Best Mode for Carrying Out the Invention

### (Example 1) Manufacturing of a ceramic heater

(1) A composition of: 100 parts by weight of aluminum nitride powder (made by Tokuyama Company, average particle diameter: 1.1 µm) ; 4 parts by weight of yttrium oxide (Y₂O₃: yttria, average particle diameter: 0.4 µm) ; and 10 parts by weight of an acrylic binder were mixed, and the mixture was put into a mold and was hot-pressed at 1890 °C and at a pressure of 15 MPa for 3 hours to obtain a nitride aluminum sintered body.
   This was cut out into a disk having a diameter of 210 mm to produce a ceramic substrate 1. This ceramic substrate 1 was subjected to be drilled to form three through holes 8 having a diameter of 10 mm.
(2) Next, a conductor containing paste was printed on the bottom surface 1b of the ceramic substrate 1 obtained in the step (1) by screen printing. The pattern of the printing was made to be a pattern of concentric circles as shown in FIG. 1.
   The used conductor containing paste was Solvest PS603D made by Tokuriki Kagaku Kenkyu-zyo, which is used to form plated through holes in printed circuit boards.
   This conductor containing paste was a silver-lead paste and containing 7.5 parts by weight of metal oxides comprising lead oxide(5 % by weight), zinc oxide (55% by weight), silica (10% by weight), boron oxide (25% by weight) and alumina (5% by weight) per 100 parts by weight of silver. The silver particles had an average particle diameter of 4.5 µm, and were scaly.
(3) Next, the sintered body on which the conductor containing . paste was printed was heated and fired at 780 °C to sinter silver and lead in the conductor containing paste and bake them onto the sintered body. Thus, heating elements 4 were formed. The resultant silver-lead heating elements 4 had a thickness of 5 µm, a width of 2.4 mm and an area resistivity of 7.7 mΩ/□.
(4) The ceramic substrate 1 subjected to the above-mentioned processing was immersed into an electroless nickel plating bath comprising an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer 5 (nickel layer) having a thickness of 1 µm on the surface of the silver-lead heating layer 4. Thus, resistance heating elements 2 were made.
(5) By screen printing, a silver-lead solder paste (made by Tanaka Kikinzoku Kogyo CO.) was printed on portions, to which terminal for attaining connection to a power source would be attached, to form a solder layer.
   Next, terminal pins 3 made of kovar were put on the solder layer 6 and the solder layer were heated and reflowed at 420 °C to attach the terminal pins 3 onto the surface of the heating elements 2.
(7) Thermocouples for temperature-control were inserted into the bottomed holes . A polyimide resin was filled into the holes and was cured at 190 °C for 2 hours . Then, this ceramic substrate (reference to FIGs. 1,2) was set on a supporting case and then connection of wires and other processes were performed to obtain a ceramic heater.

Next, lifter pins 7 were passed through the through holes 8 in the ceramic substrate 1, and a silicon wafer 9 was put on the lifter pins 7. The lifter pins 7 were slowly lowered to set the distance between the silicon wafer and the ceramic substrate to 100 µm.

The side on which the resistance heating elements 2 were not formed was made to be a heating surface 1a.

Furthermore, the temperature of the ceramic substrate 1 was raised to 600 °C and then the highest temperature and the lowest temperature of the silicon wafer 9 were measured by a thermoviewer (IR162012-0012, made by Japan Datum Company).

The highest temperature of the silicon wafer was 600 °C and the lowest temperature thereof was 595 °C. The difference between the highest temperature and the lowest temperature was 5 °C.

A fluorescent X-ray analyzer (RIX2100, made by Rigaku) was used to check contamination of the silicon wafer by Y. No contamination was found.

### (Example 2) Manufacturing of a ceramic heater having therein resistance heating elements (FIG. 3)

(1) A paste obtained by mixing 100 parts by weight of aluminum nitride powder (made by Tokuyama Corp., average particle diameter: 1.1 µm), 4 parts by weight of yttria (average particle diameter: 0.4 µm), 11.5 parts by weight of an acrylic binder, 0.5 part by weight of a dispersant, 0.2 parts by weight of an acrylic binder and 53 parts by weight of alcohols comprising 1-butanol and ethanol was formed by the doctor blade process to produce a green sheet having a thickness of 0.47 mm.
(2) Next, this green sheet was dried at 80 °C for 5 hours, and was subjected to punching to make portions which would be through holes 8, into which lifter pins having a diameter of 5.0 mm would be passed through, and portions which would be plated through holes 15 for connection to external terminals.
(3) 100 parts by weight of tungsten carbide particles having an average particle diameter of 1 µm, 3.0 parts by weight of an acrylic binder, 3.5 parts by weight of α-terpineol solvent, and 0.3 part by weight of a dispersant were mixed to produce a conductor containing paste A.
   100 parts by weight of tungsten particles having an average particle diameter of 3 µm, 1.9 parts by weight of an acrylic binder, 3.7 parts by weight of α-terpineol solvent, and 0.2 part by weight of a dispersant were mixed to produce a conductor containing paste B.
   This conductor containing paste A was printed on the green sheet by screen printing, to form a conductor containing paste layer. The printed pattern was a concentric circle pattern.
   The conductor containing paste B was filled into the through holes for plated through holes, to which external terminals would be connected.
   Thirty seven green sheets on which no tungsten paste was printed were stacked on the upper side (heating surface) of the green sheet subjected to the above-mentioned treatment, and 13 green sheets on which no tungsten paste was printed were stacked on the lower side thereof at 130 °C and a pressure of 8 MPa.
(4) Next, the resultant lamination was degreased at 600 °C in nitrogen gas for 5 hours, and hot-pressed at 1890 °C and a pressure of 15 MPa for 3 hours to obtain an aluminum nitride plate 3 mm in thickness. This was cut out into a disc of 230 mm in diameter to get a ceramic substrate 11 having therein resistance heating elements having a thickness of 6 µm and a width of 10 mm.
(5) Next, the ceramic substrate 11 obtained in the step (4) was grinded with diamond grindstone, and then a mask was put thereon to make bottomed holes 11c (diameter: 1.2 mm, depth: 2.0 mm) for thermocouples in the surface by blast treatment with SiC and the like.
(6) Furthermore, a part of the through holes for the plated through holes was hollowed out to make blind holes 16. Brazing gold comprising Ni-Au was heated and ref lowed at 700 °C to connect external terminals (non-illustrated) made of kovar to the blind holes 16.
   Regarding the connection of the external terminals, a structure, wherein a support of tungsten supports at three points, is desirable. This is because the reliability of the connection can be kept.
(7) Thermocouples for temperature-control were inserted into the bottomed holes. This ceramic substrate (reference to FIG. 3) was set on a supporting case and then connection of wires and other processes were performed. Thus, a ceramic heater was obtained.
(8) Next, lifter pins 7 were passed through the through holes 8 in the ceramic substrate 11, and a silicon wafer was supported by the lifter pins 7. The lifter pins 7 were slowly lowered to set the distance between the silicon wafer and the ceramic substrate to 150 µm. The side which was farther from the heating elements was made to a heating surface 11a.

Furthermore, the temperature of the ceramic substrate was raised to 600 °C and then the highest temperature and the lowest temperature of the silicon wafer were measured by a thermoviewer (IR162012-0012, made by Japan Datum Company).

The highest temperature of the silicon wafer was 600 °C and the lowest temperature thereof was 595 °C. The difference between the highest temperature and the lowest temperature was 5 °C.

A fluorescent X-ray analyzer (RIX2100, made by Rigaku) was used to check contamination of the silicon wafer by Y. No contamination was found.

### (Example 3) Manufacturing of a ceramic substrate having supporting pins 20

Basically, the same manner as in Example 1 was carried out, but through holes 41: each of which is composed of connected holes, a diameter of said hole at the heating surface side of the ceramic substrate was 5 mm and a diameter of said hole at the side opposite thereto was 3 mm; were formed(reference to FIG. 5). Supporting pins 30 having a shape shown in FIG. 4 (a) which is made of alumina were fitted into the holes. Regarding the supporting pins 30, the diameter of fitting-in portions 22 was about 5 mm, and the diameter of fixing portions 24 was 3 mm. The length of the pins 30 was about 6.1 mm. The pins 30 were structured in such a manner that the fixing portions 24 were exposed from a bottom surface 1b of the ceramic substrate 1. C figure-shaped metal members 27 (reference to FIG. 5(b)) made of stainless steel were fitted between the fixing portions 24 and the bottom surface (face opposite to the heating surface) 1b of the ceramic substrate.

The supporting pins 20 projected by 100 µm from the wafer heating surface 1a.

### (Example 4) Manufacturing of a ceramic substrate having supporting pins 30

Basically, the same manner as in Example 1 was carried out, but concave portions 42 having a diameter of 3 mm and a depth of 2 mm were formed in a heating surface side of a ceramic substrate 1. Supporting pins 30 having a shape shown in FIG. 4 (b) and made of alumina were inserted into the concave portions. Regarding the supporting pins 30, the diameter of pillar-shaped portions 31 was about 2 mm, and the diameter of fixing portions 32 was about 3 mm. The length of the pins 30 was about 3.1 mm. C figure-shaped springs 37 made of stainless steel were fitted into the concave portions 42 to fix the supporting pins 30.

The supporting pins 30 projected by 100 µm from the wafer heating surface 1a.

### (Example 5) Manufacturing of a ceramic substrate having convex portions

Basically, the same manner as in Example 1 was carried out, but, by hot press conical-shaped convex portions 81d as shown in FIG. 8 were formed on the surface. The height of the convex portions 81d was about 400 µm.

### (Example 6) Manufacturing of a heater with an electrostatic chuck

Basically, the same manner as in Example 2 was carried out, but when the conductive paste A was printed on a green sheet by screen printing to form a conductor containing paste layer, a heating element pattern of concentric circles was printed and, besides it, a pattern of dipolar electrostatic electrodes was printed on another green sheet.

Furthermore, through holes 41 were formed in the ceramic substrate 1 in the same manner as in Example 3. Supporting pins 20 were passed through the through holes 41 and fixed by metal members 27 to obtain a ceramic substrate having a structure shown in FIG. 7. The supporting pins 20 were adjusted to project by 300 µm from the heating surface 1a.

On the ceramic heaters according to Examples 1 to 6, the temperatures of silicon wafers were measured by the thermoviewer (IR162012-0012, made by Japan Datum Company) to obtain the highest temperature and the lowest temperature thereof. A fluorescent X-ray analyzer (RIX2100, made by Rigaku) was used to check contamination of the silicon wafer by Y. The results are shown in Table 1.

### (Example 7) Hot plate made of SiC

(1) A composition comprising 100 parts by weight of silicon carbide powder (Diyasic GC - 15, made by Yakushima Denko Co., Ltd., average particle diameter: 1.1 µm), 4 parts by weight of carbon, 12 parts by weight of an acrylic resin binder, 5 parts by weight of B₄C, 0.5 part by weight of a dispersant, 1-butanol, ethanol, and alcohol were spray-dried to produce granular powder.
(2) Next, the granular powder was put into a mold and formed into a flat plate form. Thus, a formed body was obtained.
(3) The formed body subjected to the processing was hot-pressed at a temperature of 1900 °C and a pressure of 20 MPa to obtain a silicon carbide sintered body having a thickness of 3 mm.
(4) Next, this silicon carbide sintered body was subjected to annealing treatment at 1600 °C in nitrogen gas for 3 hours, and subsequently this plate was cut out into a disc having a diameter of 210 mm to produce a plate body made of the ceramic (ceramic substrate 11).
   Furthermore, glass paste (G - 5270, made by Shoei Chemical Industries Co., Ltd.) was applied to the surface thereof. Thereafter, the plate was heated at 600 °C to melt the paste, and thus form a SiO₂ layer having a thickness of 2 µm on the surface.
   Next, this ceramic substrate was drilled and processed with a cutting tool or material to form: through holes 15, into which lifter pins would be passed through; through holes, into which lifter pins for supporting a silicon wafer would be passed through; and bottomed holes 14 (diameter: 1.1 mm, depth: 2 mm), in which thermocouples would be buried. Further, one concave portion at the center; and three concave portions arranged at equal intervals on a concentric circle: were formed in the wafer-heating surface side.
(5) Next, a conductor containing paste was printed on the bottom surface of the sintered body obtained in the step (3) by screen printing. The pattern of the printing was made to a pattern of concentric circles as shown in FIG. 1.
   The used conductor containing paste was Solvest PS603D made by Tokuriki Kagaku Kenkyu-zyo, which is used to form plated through holes in printed boards.
   This conductor containing paste was a silver-lead oxide paste and containing 7.5 parts by weight of metal oxides comprising lead oxide (5 % by weight), zinc oxide (55% by weight), silica (10% by weight) , boron oxide (25% by weight) and alumina (5% by weight) per 100 parts by weight of silver. The silver particles had an average particle diameter of 4.5 µm, and were scaly.
(6) Next, the sintered body on which the conductor containing paste was printed was heated and fired at 780 °C to sinter silver and lead in the conductor containing paste and bake them on the sintered body. Thus, resistance heating elements 12 were formed. The resistance heating elements of silver-lead 12 had a thickness of 5 µm, a width of 2.4 mm and an area resistivity of 7.7 mΩ/□ at the neighboring of their terminal portions.
(7) Next, the above-mentioned glass paste was applied to the surface. The resultant was fired at 600 °C so that a glass coating was deposited on the surface.

At last, alumina balls for supporting a wafer were fitted in the central portion and the three concave portions around it.

### (Comparative Example 1)

The same manner as in Example 1 was carried out, but the silicon wafer was brought into contact with the ceramic substrate. The same measurement was then carried out. The highest temperature of the silicon wafer was 605 °C, and the lowest temperature was 595 °C. The difference between the highest temperature and the lowest temperature was 10 °C.
The fluorescent X-ray analyzer (RIX2100, made by Rigaku) was used to check contamination of the silicon wafer by Y. It was observed that Y diffused slightly on the back surface of the silicon wafer.

### (Test Example 1)

The same manner as in Example 1 was carried out, but the distance between the silicon wafer and the ceramic substrate was set to 3 µm. The same measurement was then carried out. The highest temperature of the silicon wafer was 605 °C, and the lowest temperature was 595 °C. The difference between the highest temperature and the lowest temperature was 10 °C. The fluorescent X-ray analyzer (RIX2100, made by Rigaku) was used to check contamination of the silicon wafer by Y. No contamination was observed.

### (Test Example 2)

The same manner as in Example 1 was carried out, but the distance between the silicon wafer and the ceramic substrate was set to 510 µm. The same measurement was then carried out. The highest temperature of the silicon wafer was 597 °C, and the lowest temperature was 594 °C. This shows the fact that, although the temperature of the ceramic substrate was raised to 600 °C, the temperature of the silicon wafer was somewhat low. Then, the ceramic substrate was observed with a thermoviewer. As a result, the highest temperature of the silicon wafer was 605 °C, and the lowest temperature was 595 °C. The difference between the highest temperature and the lowest temperature was 10 °C. The fluorescent X-ray analyzer (RIX2100, made by Rigaku) was used to check contamination of the silicon wafer by Y. No contamination was observed.

### (Test Example 3)

The same manner as in Example 1 was carried out, but the distance between the silicon wafer and the ceramic substrate was set to 5100 µm. The same measurement was then carried out. The highest temperature of the silicon wafer was 400 °C, and the lowest temperature was 410 °C. The difference between the highest temperature and the lowest temperature was 10 °C. Although the temperature of the ceramic substrate was raised to 600 °C, the temperature of the silicon wafer did not rise sufficiently. The ceramic substrate was observed with a thermoviewer. As a result, the highest temperature of the silicon wafer was 605 °C, and the lowest temperature was 595 °C. The difference between the highest temperature and the lowest temperature was 10 °C. The fluorescent X-ray analyzer (RIX2100, made by Rigaku) was used to check contamination of the silicon wafer by Y. No contamination was observed.

The results of Examples, the Comparative Example and Test Examples are shown in Table 1.

In Example 7, the separated distance was 50 µm, the highest temperature was 600 °C, and the lowest temperature was 595 °C. No contamination by yttria was found.

Heating up to 150 °C was performed, and a wafer having a temperature of 25 °C was put on. The time until the heating temperature recovered to 150 °C was measured. In Examples 1 to 7, the time was about 25 seconds. On the other hand, in the Comparative Example and Test Example 1, the time was 50 seconds. In Test Example 2, the time was about 35 seconds. In Test Example 3, the time was 30 seconds.

**Table 1**

| | Separating distance (µm) | Highest temperature (°C) | Lowest temperature (°C) | Contamination by Y |
|---|---|---|---|---|
| Example 1 | 100 | 600 | 595 | None |
| Example 2 | 150 | 600 | 595 | None |
| Example 3 | 100 | 600 | 595 | None |
| Example 4 | 100 | 600 | 595 | None |
| Example 5 | 400 | 598 | 595 | None |
| Example 6 | 300 | 600 | 598 | None |
| Comparative Example 1 | 0 | 605 | 595 | Observed |
| Test Example 1 | 3 | 605 | 595 | None |
| Test Example 2 | 510 | 597 | 594 | None |
| Test Example 3 | 5100 | 400 | 410 | None |

As is clear from the results shown in Table 1, in the Comparative Example 1, the temperature distribution of the ceramic substrate is reflected, as it is, on the temperature distribution of the silicon wafer. In Test Example 1, the temperature difference on the surface of the ceramic substrate is also reflected, as it is, on the temperature difference in the silicon wafer. Thus, it can not be said that temperature uniformity is sufficient. On the other hand, in Test Example 2, the temperature of the silicon wafer is slightly lower than that of the ceramic substrate . InTest Example 3, the temperature of the silicon wafer is extremely lower than that of the surface of the ceramic substrate. Thus, Test Example 3 is not practical.

In the ceramic substrates according to Examples 3,4, the supporting pins are fixed. Therefore, the distance between the silicon wafer and the heating surface of the ceramic substrate can always be made constant even if the distance is not adjusted. The supporting pins are physically fixed and are not easily damaged or deteriorated by heat. Also, dropping-out thereof is not caused.

In the ceramic substrate according to Example 5, the conical-shaped convex portions are formed on the surface of heating surface. The effort to fix the supporting pins and so on is not needed. Since the supporting pins need not be fixed, it is unnecessary to use a spring made of a metal, or a metal member for fixing. Also, any cooling spot, where the temperature thereof becomes extremely low, is not generated around the supporting pins.

In the ceramic substrate according to Example 6, the silicon wafer is sucked by the electrostatic chuck so that warp or strain of the silicon wafer can be directed in one direction and the temperature difference in the silicon wafer can be virtually eliminated.

As is clear from the measurement results, shown in Table 1, of contamination of the silicon wafer by Y in Examples 1 to 6, diffusion of Y into the silicon wafer can be completely prevented by separating the silicon wafer from the ceramic substrate.

### Industrial Applicability

As described above, on the ceramic heater according to the present invention, a semiconductor wafer can be heated at a uniform temperature. Moreover, contamination of the semiconductor wafer can be prevented. The supporting pin of the present invention does not drop out even if it is heated. As a result, the distance between the semiconductor wafer and the heating surface of the ceramic substrate can be made constant at any time.

## Claims

1. A ceramic heater comprising a ceramic substrate, on a surface of which or inside which, a heating element is formed,
wherein above said ceramic heater is constituted to have a structure that an object to be heated can be held apart from a surface of said ceramic substrate and heated.

2. A ceramic heater comprising a ceramic substrate, on a surface of which or inside which, a heating element is formed,
wherein said ceramic heater is constituted:
to have a structure that a face of said ceramic substrate on which no heating element is formed, or one face of said ceramic substrate is made to be a heating surface; and
to have a structure that an object to be heated can be held apart from said heating surface and heated.

3. The ceramic heater according to claim 1 or 2,
wherein a through hole, in which a supporting pin for holding the object to be heated is passed through, is formed in said ceramic substrate.

4. The ceramic heater according to any of claim 1,2 or 3,
wherein said object to be heated is 5 to 5000 µm apart from the surface or the heating surface of said ceramic substrate.

5. The ceramic heater according to claim 1 or 2,
wherein a convex body or a convex portion is formed on the surface of said ceramic substrate.

6. The ceramic heater according to claim 5,
wherein a through hole is formed in said ceramic substrate, and a supporting pin is passed through and fixed into said through hole so that the convex body is formed on the surface of said ceramic substrate.

7. The ceramic heater according to claim 5,
wherein a concave portion is formed on the heating surface of said ceramic substrate, and a supporting pin is inserted and fixed into said concave portion so that the convex body is formed on the surface of said ceramic substrate.

8. A supporting pin,
wherein:
a contact portion formed at a tip;
a fitting-in portion formed under said contact portion which has a larger diameter than that of said contact portion;
a pillar-shaped body formed under said fitting-in portion which has a smaller diameter than that of said fitting-in portion; and
a fixing portion formed on the lower end of said pillar-shaped body which has a larger diameter than that of the pillar-shaped body;
are integrated to one body.

9. A supporting pin,
wherein:
a pillar-shaped body; and
a fixing portion having a larger diameter than that of said pillar-shaped body
are integrated to one body.

10. The supporting pin according to claim 9,
wherein a tip of said pillar-shaped body is in a spire shape or in a hemispherical shape.

11. A ceramic heater:
comprising a ceramic substrate, on a surface of which or inside which, a heating element is formed; and
which is constituted to have a structure that an object to be heated can be held apart from a surface of said ceramic substrate and heated,
wherein:
a through hole composed of connected holes, said holes having mutually different diameters, is formed in said ceramic substrate;
the supporting pin according to claim 8 is passed through said through hole;
the fitting-in portion of said supporting pin is inserted and fitted into the portion with the relatively large diameter of said through hole; and
a metal member for fixing is fitted in between the fixing portion of said supporting pin and the bottom surface of said ceramic substrate.

12. A ceramic heater:
comprising a ceramic substrate, on a surface of which or inside which, a heating element is formed; and
which is constituted to have a structure that an object to be heated can be held apart from a surface of said ceramic substrate and heated,
wherein:
a concave portion is formed in the heating surface side of said ceramic substrate;
the supporting pin according to claim 9 is inserted into said concave portion; and
a spring for fixing is fitted to said concave portion so as to contact the wall surface of said concave portion in the state that the spring for fixing surrounds said pillar-shaped body.

13. The ceramic heater according to any of claims 1 to 7, 11, and 12,
wherein an electrostatic electrode is set up inside said ceramic substrate.
